# FASCICULE DE BREVET EUROPEEN

(11) **EP 2 728 986 B1**
(45) Date de publication et mention de la délivrance du brevet: **19.07.2017**
(21) Numéro de dépôt: 13187967.8
(22) Date de dépôt: 09.10.2013
(51) Int. Cl.: H05K 7/20, F04D 27/00

(54) **Surveillance du fonctionnement d'un système de dissipation thermique**
Betriebsüberwachung eines Wärmeableitungssystems
Monitoring of the operation of a heat-dissipation system

(30) Priorité: 06.11.2012 FR 1260518
(43) Date de publication de la demande: 07.05.2014
(73) Titulaire: Schneider Electric Industries SAS, 92500 Rueil-Malmaison (FR)
(72) Inventeur: Lopez, Josep, 08390 Montgat (Barcelona) (ES); Perrin, Alain, 38500 Saint Nicolaas de Macherin (FR)
(74) Mandataire: Novaimo

(56) Documents cités:
- US-A- 5 835 786
- US-A- 6 009 362
- US-B1- 6 400 113
- US-B1- 6 528 987

## Description

L'invention concerne un procédé et un dispositif de surveillance du fonctionnement d'un système de dissipation thermique comprenant au moins un ventilateur assurant une circulation d'air de refroidissement, et éventuellement au moins un élément de filtration de l'air circulant lorsque le ventilateur présente une vitesse de rotation non nulle.

L'invention a pour objet également un procédé de surveillance d'une armoire de contrôle renfermant au moins un organe électrique et équipée d'au moins une ouverture de ventilation, l'armoire de contrôle comprenant au moins un premier système de dissipation thermique placé dans l'armoire de contrôle et ayant un ventilateur régulant la température de l'organe électrique et/ou au moins un deuxième système de dissipation thermique ayant un ventilateur faisant circuler de l'air à travers l'ouverture de ventilation pour amener de l'air dans l'armoire de contrôle et/ou pour extraire de l'air en dehors de l'armoire de contrôle. Elle concerne enfin une armoire de contrôle en tant que telle.

Actuellement, les armoires de contrôle de machines intègrent des équipements électriques qui dissipent de la chaleur sous forme de calories. Cette chaleur dégagée au sein des armoires de contrôle doit être évacuée pour garantir le bon fonctionnement des armoires de contrôle et des équipements électriques qu'elles renferment. Les armoires de contrôle comprennent dès lors un système de dissipation thermique qui nécessite des ouïes de ventilation pour amener de l'air de refroidissement dans l'armoire de contrôle et pour l'évacuer hors de l'armoire de contrôle.

Le système de dissipation thermique est généralement constitué par un simple ventilateur ou par une climatisation comprenant un échangeur et un condenseur. Dans les deux cas, un ventilateur de type axial ou radial assure une circulation de l'air.

Comme l'air entrant doit être dépollué, la solution classique utilisée est de disposer un filtre qui possède une capacité d'absorption de la poussière attendue. Plusieurs classes de qualification d'un filtre à air existent en fonction de l'efficacité de gravimétrie minimale du filtre, notamment les classes repérées « G1 » à « G4 » pour une gravimétrie grossière du filtre.

Les armoires de contrôle sont installées chez les clients finaux avec la machine associée dans des environnements variable, parfois présentant des conditions sévères, au sein d'un bâtiment ou à l'extérieur, parfois dans le désert. La performance du système de dissipation thermique dépend en particulier du niveau l'encrassement du filtre.

Une problématique additionnelle pour la conception d'une armoire de contrôle est le contrôle du débit d'air à l'intérieur de l'armoire pour dissiper correctement les calories tout en évitant les points chauds susceptibles de détériorer un équipement électrique interne. Le débit d'air peut être réduit par l'implantation d'un appareil ou le cheminement de câbles électriques à l'endroit où l'air circule :
- il peut s'agir du cas d'une superposition en profondeur d'appareils,
- il peut s'agir du cas d'une armoire dont la profondeur s'avère trop faible au fil de son évolution car les appareils remplacés peuvent présenter des formes ou des dimensions différentes ou bien les évolutions de câblages peuvent engendrer l'implantation de fils et de câbles sur le chemin de circulation de l'air,
- il peut enfin s'agir du cas d'une obturation partielle des systèmes de dissipation des équipements électriques.

Lorsque la machine est installée avec son armoire de contrôle, l'utilisateur assure généralement la maintenance des filtres. Souvent cette opération est négligée ou oubliée. Il en résulte une performance du système de dissipation thermique réduite et peut engendrer des désordres ou des dysfonctionnements des appareils, pouvant mener à une panne susceptible d'arrêt de production.

Il est connu de prévoir un volet doté d'un micro rupteur signalant l'encrassement du filtre de façon binaire (encrassé - non encrassé). Ainsi, ce signalement est émis lorsque la situation de fonctionnement normal est dépassée, ce qui n'est pas satisfaisant. Une solution équivalente est décrite par exemple dans le document WO2011131421.

Il est également connu de surveiller la température intérieure de l'armoire de contrôle et d'adapter la vitesse de ventilation pour compenser l'encrassement du filtre. Cette solution palliative, par exemple décrite dans le document JP2003322380, conduit à user prématurément le ventilateur qui est bien souvent déjà un composant critique.

Les appareils domestiques tels que les aspirateurs ou les machines à laver utilisent un capteur qui mesure une différence de pression afin de s'assurer que le niveau de dépression à un emplacement est toujours significativement inférieur à celui d'un autre emplacement. Ce système ne peut être utilisé dans le cas d'une armoire de contrôle car les différences de pression sont trop faibles et rend ce capteur inutilisable. De telles solutions basées sur la pression sont par exemple décrites dans les documents WO2011145186 et JP8021648.

Il est aussi connu d'utiliser des cellules photoélectriques mesurant la densité de poussière et la différence de vitesse de circulation d'air. Une telle solution est par exemple décrite dans le document WO2011131421.

Dans les autres solutions connues, il est nécessaire de fixer une valeur de référence de tension, une valeur de référence de vitesse, un niveau de référence de poussière ou de température, préalablement à toute utilisation du système de dissipation thermique. De telles solutions sont par exemple décrites dans les documents KR20030009960 et FR2769265. Mais la détermination préalable de telles valeurs de référence ou de tels niveaux de référence est très délicate à mettre en oeuvre car ils doivent tenir compte des paramètres d'utilisation tels que l'altitude et les conditions d'exploitation.

Enfin, l'utilisateur réalisant la maintenance du filtre n'a pas toujours à sa disposition le filtre adapté ou adéquat et il arrive fréquemment qu'il le remplace par un filtre non adapté voire même qu'il le supprime. De tels risques liés à l'utilisation sont insatisfaisants.

Les documents US6528987B1, US6400113B1, US5835786A et US6009362A décrivent des solutions qui ne répondent pas aux problématiques précédentes.

Le but de la présente invention est de proposer une solution de surveillance du fonctionnement d'un système de dissipation thermique qui remédie aux inconvénients listés ci-dessus, notamment qui soit simple de mise en oeuvre et qui en outre permette une surveillance et un signalement préventifs.

Un autre aspect de l'invention est de fournir une telle solution permettant :
- d'organiser des opérations de maintenance, notamment en établissant une périodicité,
- de prévenir toute panne du ventilateur,
- de détecter la présence d'un filtre et d'un bon niveau de gravimétrie de ce dernier, permettant in fine de garantir autant que possible un bon fonctionnement,
- de mesurer le niveau d'encrassement du filtre de manière simple,
- de surveiller la bonne circulation de l'air dans l'armoire de contrôle au cours de son exploitation et d'alerter l'utilisateur en cas de nécessité,
- de localiser un filtre encrassé et/ou un équipement électrique refroidi en souffrance afin de prévenir un arrêt ou une panne de la machine.

Un premier aspect de l'invention concerne un procédé de surveillance du fonctionnement d'un système de dissipation thermique comprenant au moins un ventilateur assurant une circulation d'air de refroidissement, comprenant la mise en oeuvre d'au moins un cycle d'étapes au cours duquel le ventilateur fonctionne et comprenant les étapes suivantes :
- établissement d'une valeur de référence de vitesse de rotation du ventilateur durant le fonctionnement du ventilateur notamment sensiblement en début de cycle,
- suivi de l'évolution dans le temps de la vitesse de rotation du ventilateur,
- notification d'un besoin d'intervention sur le système de dissipation thermique lorsque le rapport entre la vitesse de rotation du ventilateur durant l'étape de suivi et la valeur de référence de vitesse de rotation du ventilateur établie, est inférieur à un seuil prédéterminé non nul, notamment de l'ordre de 0,75.

Le système de dissipation thermique peut comprendre au moins un élément de filtration de l'air circulant lorsque le ventilateur présente une vitesse de rotation non nulle et dans ce cas l'étape de notification comprendra de préférence une étape de signalement de la nécessité de remplacement dudit élément de filtration.

L'étape de notification pourra comprendre une étape de signalisation à destination d'un opérateur de maintenance du système de dissipation thermique, notamment une étape de signalisation visuelle, en particulier une étape d'affichage d'un témoin lumineux.

L'étape de suivi pourra comprendre une étape de mesure périodique de la vitesse de rotation instantanée du ventilateur.

L'étape d'établissement de la valeur de référence de vitesse de rotation du ventilateur pourra comprendre une étape de mesure unique de la vitesse de rotation instantanée du ventilateur réalisée à la fin d'une période d'apprentissage de fonctionnement du ventilateur à une vitesse de rotation non nulle.

Il pourra être fait en sorte que le cycle d'étapes soit itératif de sorte que le procédé comprenne la mise en oeuvre :
- d'un cycle initial d'étapes dont l'étape d'établissement fournit une valeur initiale de référence de vitesse de rotation du ventilateur,
- puis d'au moins un cycle d'étapes suivant, pour chacun desquels l'étape d'établissement fournit une nouvelle valeur de référence de vitesse de rotation du ventilateur.

Un cycle d'étapes est de préférence mis en oeuvre lors du premier fonctionnement du système de dissipation thermique et/ou sur demande d'un opérateur de maintenance et/ou automatiquement à chaque démarrage du système de dissipation thermique ou du ventilateur et/ou automatiquement à chaque changement de l'élément de filtration.

A la mise en oeuvre d'un cycle d'étapes suivant le cycle initial d'étapes, le procédé pourra comprendre une étape de comparaison de la nouvelle valeur de référence de vitesse de rotation du ventilateur par rapport à la valeur initiale de référence de vitesse de rotation du ventilateur établie durant le cycle initial d'étapes, et une étape de diagnostic du système de dissipation thermique en fonction du résultat de l'étape de comparaison.

L'étape de diagnostic pourra comprendre une étape d'évaluation de l'usure du ventilateur en fonction de la différence entre la valeur initiale de référence de vitesse de rotation du ventilateur établie durant le cycle initial d'étapes et la nouvelle valeur de référence de vitesse de rotation du ventilateur lorsque ladite différence est positive.

L'étape de diagnostic pourra comprendre une étape de vérification de la présence et/ou de la gravimétrie de l'élément de filtration en fonction de la différence entre la nouvelle valeur de référence de vitesse de rotation du ventilateur et la valeur initiale de référence de vitesse de rotation du ventilateur établie durant le cycle initial d'étapes lorsque ladite différence est positive.

Il peut être prévu une étape de détermination de la périodicité de remplacement de l'élément de filtration en fonction de la durée dudit au moins un cycle d'étapes.

Le procédé pourra comprendre une étape de signalement d'une défaillance du ventilateur lorsque, durant toute étape de suivi de l'évolution dans le temps de la vitesse de rotation du ventilateur, la vitesse de rotation du ventilateur devient nulle.

Un deuxième aspect de l'invention concerne un procédé de surveillance d'une armoire de contrôle renfermant au moins un organe électrique et équipée d'au moins une ouverture de ventilation, l'armoire de contrôle comprenant au moins un premier système de dissipation thermique placé dans l'armoire de contrôle et ayant un ventilateur régulant la température de l'organe électrique et/ou au moins un deuxième système de dissipation thermique ayant un ventilateur faisant circuler de l'air à travers l'ouverture de ventilation pour amener de l'air dans l'armoire de contrôle et/ou pour extraire de l'air en dehors de l'armoire de contrôle. Ce procédé comprend alors la mise en oeuvre d'un procédé de surveillance du fonctionnement dudit au moins un premier système de dissipation thermique et/ou dudit au moins un deuxième système de dissipation thermique, tel que présenté précédemment.

Un troisième aspect de l'invention concerne un dispositif de surveillance du fonctionnement d'un système de dissipation thermique comprenant au moins un ventilateur assurant une circulation d'air de refroidissement, comprenant les éléments logiciels et/ou matériels qui mettent en oeuvre l'un des deux procédés précédents.

Enfin un quatrième aspect de l'invention concerne une armoire de contrôle renfermant au moins un organe électrique et équipée d'au moins une ouverture de ventilation, l'armoire de contrôle comprenant au moins un premier système de dissipation thermique placé dans l'armoire de contrôle et ayant un ventilateur régulant la température de l'organe électrique et/ou au moins un deuxième système de dissipation thermique ayant un ventilateur faisant circuler de l'air à travers l'ouverture de ventilation pour amener de l'air dans l'armoire de contrôle et/ou pour extraire de l'air en dehors de l'armoire de contrôle. L'armoire de contrôle comporte alors au moins un tel dispositif de surveillance surveillant le fonctionnement dudit au moins un premier système de dissipation thermique et/ou dudit au moins un deuxième système de dissipation thermique.

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- les figures 1 à 3 sont trois courbes illustrant l'évolution, en fonction du temps en abscisses, de la vitesse de rotation d'un ventilateur notée « RPM », pour des procédés de surveillance selon l'invention,
- les figures 4 à 8 illustrent schématiquement des exemples d'armoires de contrôle munies de dispositif de surveillance selon l'invention et mettant en oeuvre le procédé de surveillance.

De manière générale, la description suivante concerne un procédé de surveillance du fonctionnement d'un système de dissipation thermique comprenant au moins un ventilateur (de type axial ou radial) assurant une circulation d'air de refroidissement. Elle concerne aussi un dispositif de surveillance du fonctionnement du système de dissipation thermique, comprenant pour cela les éléments logiciels et/ou matériels qui mettent en oeuvre le procédé de surveillance.

De manière essentielle, le procédé de surveillance comprend la mise en oeuvre d'au moins un cycle d'étapes au cours duquel le ventilateur fonctionne et comprenant les étapes suivantes :
- établissement d'une valeur de référence de vitesse de rotation du ventilateur durant le fonctionnement du ventilateur notamment sensiblement en début de cycle,
- suivi de l'évolution dans le temps de la vitesse de rotation du ventilateur,
- notification d'un besoin d'intervention sur le système de dissipation thermique lorsque le rapport entre la vitesse de rotation du ventilateur durant l'étape de suivi et la valeur de référence de vitesse de rotation du ventilateur établie, est inférieur à un seuil prédéterminé non nul.

Ceci permet de détecter le niveau de performance globale du système de circulation d'air sans qu'il soit nécessaire de prédéterminer une quelconque valeur de référence de RPM préalablement au fonctionnement du ventilateur. Il a été validé en effet qu'à tension d'alimentation contrôlée équivalente, la vitesse de ventilation est directement liée à la qualité de circulation de l'air (i. e. le flux en m³/h).

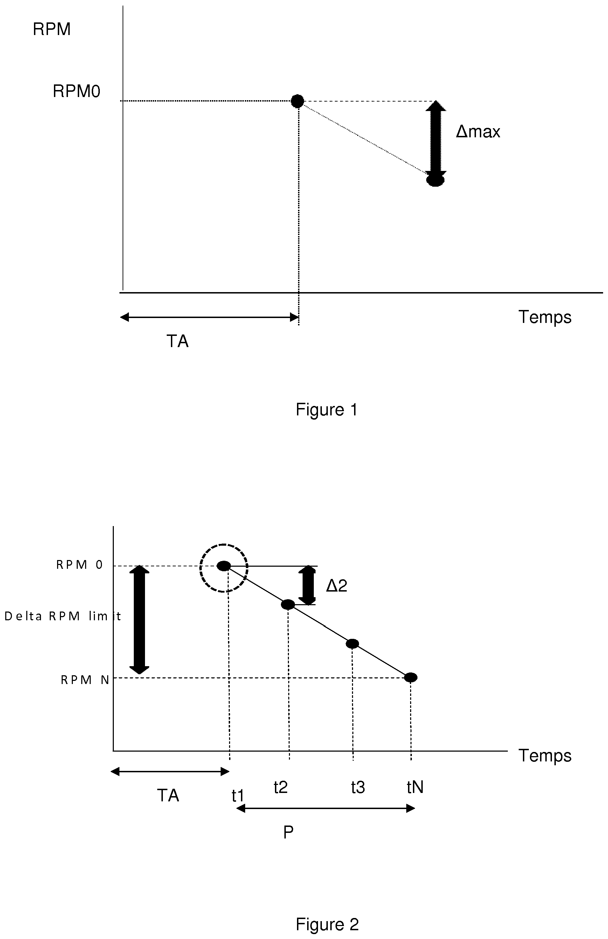

Le suivi de l'évolution dans le temps noté « Temps » sur les figures 1 à 3 peut être réalisé de manière périodique comme cela est illustré mais il est possible d'envisager un suivi continu. La vitesse de rotation peut correspondre avantageusement, par simplicité, à une valeur de nombre de rotations par minute repérée « RPM » pour « Rotation per Minute » en terminologie anglo-saxonne.

Les RPM sont mesurées par tout moyen adéquat. Par exemple, il est possible de disposer un aimant sur une pale du ventilateur en prenant la précaution de rééquilibrer le poids de chaque pale et de positionner un capteur inductif fixe sur la trajectoire de l'aimant. Il aussi possible d'utiliser un contrôleur ou d'intégrer un capteur directement dans le rotor du ventilateur pour accéder à la valeur du nombre de rotations par minute RPM du rotor.

Dans le cas particulier où le système de dissipation thermique comprend au moins un élément de filtration de l'air circulant lorsque le ventilateur présente une vitesse de rotation non nulle, l'étape de notification comprend avantageusement une étape de signalement de la nécessité de remplacement de l'élément de filtration.

Un élément de filtration, durant le fonctionnement du ventilateur, a tendance au cours du temps à se colmater. L'évolution de la vitesse de rotation du ventilateur ou « RPM » sur les figures 1 à 3, en raison de la perte de charge induite par l'élément de filtration, correspond à une courbe décroissante, notamment pouvant être assimilée à une droite affine à coefficient directeur de valeur négative.

Sur la figure 1, la valeur de référence de vitesse de rotation du ventilateur établie à l'étape d'établissement est repérée « RPM ». L'étape de notification est symbolisée par le fait que son déclenchement est automatiquement prévu lorsque le rapport entre la vitesse de rotation du ventilateur durant l'étape de suivi (qui évolue le long de la droite affine) et la valeur de référence de vitesse de rotation du ventilateur RPMO établie, est inférieur à un seuil prédéterminé non nul repéré « Δmax », notamment de l'ordre de 0,75.

Dans le mode particulier de réalisation, l'étape d'établissement de la valeur de référence de vitesse de rotation du ventilateur RPMO comprend une étape de mesure unique de la vitesse de rotation instantanée du ventilateur réalisée à la fin d'une période d'apprentissage TA de fonctionnement du ventilateur à une vitesse de rotation non nulle. Par exemple, la mesure du nombre de rotation par minutes du ventilateur est réalisée après une période probatoire d'apprentissage TA supérieure à deux minutes pour filtrer les perturbations occasionnelles et normales (ouverture et fermeture rapide d'une porte de l'armoire de contrôle, passage d'un obstacle...).

Avantageusement, la notification du besoin d'intervention sur le système de dissipation thermique pourra comprendre une signalisation à destination d'un opérateur de maintenance du système de dissipation thermique, notamment de type signalisation visuelle, en particulier par l'intermédiaire d'un affichage par témoin lumineux. De manière générale, l'alerte peut être envoyée par exemple au travers d'une console de commande ou tout autre moyen adéquat.

En référence à la figure 2 maintenant, l'étape de suivi pourra comprendre une mesure périodique de la vitesse de rotation instantanée du ventilateur. L'instant repéré « t1 » correspond à l'instant de l'établissement de la valeur de référence de vitesse de rotation du ventilateur « RPM 0 », tandis que les instants repérés « t2 », « t3 » et « tN » correspondent à des instants de mesures ultérieures, à intervalles réguliers ou non, de la vitesse de rotation instantanée du ventilateur. A chaque instant « t2 », « t3 » et « tN », la différence entre la valeur de référence de vitesse de rotation du ventilateur RPM 0 et la vitesse de rotation RPM instantanée du ventilateur est calculée. Par exemple, pour l'instant « t2 », cette différence ainsi calculée est repérée Δ2. Si à l'instant « tN » la vitesse de rotation instantanée repérée « RPM N » est telle que la différence entre « RPM 0 » et « RPM N » est supérieure au seuil prédéterminé repéré « Delta RPM limit » sur la figure 2, alors la notification d'un besoin d'intervention est réalisée.

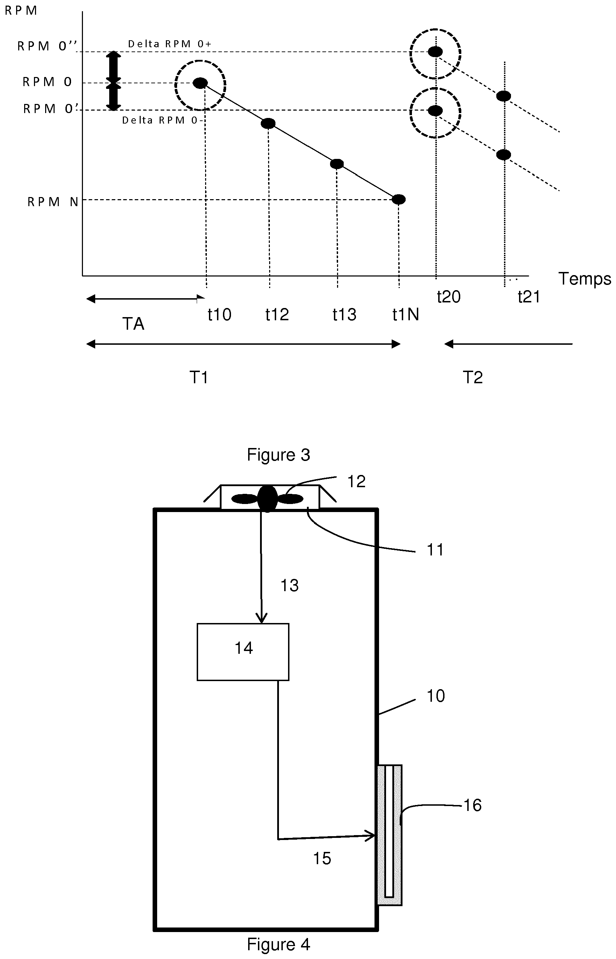

En référence à la figure 3 maintenant, le procédé de surveillance selon l'invention sera avantageusement tel que le cycle d'étapes décrit ci-dessus soit itératif de sorte que ce cycle soit répété et que le procédé comprenne la mise en oeuvre :
- d'un cycle initial d'étapes, durant une première période T1, dont l'étape d'établissement fournit une valeur initiale de référence de vitesse de rotation du ventilateur repérée « RPM 0 »,
- puis d'au moins un cycle d'étapes suivant durant une deuxième période T2, pour chacun desquels l'étape d'établissement fournit une nouvelle valeur de référence de vitesse de rotation du ventilateur.

De manière générale, un cycle d'étapes pourra être mis en oeuvre lors du premier fonctionnement du système de dissipation thermique et/ou sur demande d'un opérateur de maintenance et/ou automatiquement à chaque démarrage du système de dissipation thermique ou du ventilateur et/ou automatiquement à chaque changement de l'élément de filtration.

De la manière décrite en référence à la figure 2, la première période T1 correspondra à la mise en oeuvre de la période d'apprentissage TA, puis aux intervalles de temps entre l'instant t10 et les instants suivants t11, t12 etc... jusqu'à l'instant t1N où le cycle initial d'étapes se termine avec la mise en oeuvre d'une étape de notification d'un premier besoin d'intervention (la vitesse de rotation instantanée « RPM N » étant telle que la différence entre « RPM 0 » et « RPM N » est supérieure au seuil prédéterminé repéré « Delta RPM limit » sur la figure 2 ou « Δmax » sur la figure 1).

A la mise en oeuvre durant une deuxième période T2 d'un cycle d'étapes suivant le cycle initial d'étapes (à l'issue de la première période T1), le procédé comprend la mise en oeuvre d'une nouvelle étape d'établissement d'une nouvelle valeur de référence de vitesse de rotation du ventilateur à un instant t20. Puis l'étape de suivi de l'évolution dans le temps de la vitesse de rotation du ventilateur comprend par exemple une mesure de la vitesse instantanée de rotation du ventilateur à l'instant repéré « t21 ». Le premier cycle d'étapes ultérieur cessera à l'issue de la période T2 au moment où, une fois encore, la différence entre la valeur de référence établie à l'instant t20 et la vitesse instantanée devient supérieure au seuil prédéterminé repéré « Delta RPM limit » sur la figure 2 ou « Δmax » sur la figure 1.

Avantageusement, à la mise en oeuvre d'un cycle d'étapes suivant le cycle initial d'étapes, une comparaison est réalisée entre la nouvelle valeur de référence de vitesse de rotation du ventilateur et la valeur initiale de référence de vitesse de rotation du ventilateur « RPM 0 » établie durant le cycle initial d'étapes. Un diagnostic du système de dissipation thermique est ensuite mis en oeuvre à partir du résultat de cette comparaison. Deux cas sont alors possibles :
- la nouvelle valeur de référence de vitesse de rotation du ventilateur est inférieure à la valeur initiale de référence de vitesse de rotation du ventilateur « RPM 0 »,
- la nouvelle valeur de référence de vitesse de rotation du ventilateur est supérieure à la valeur initiale de référence de vitesse de rotation du ventilateur « RPM 0 ».

Dans le premier cas, la différence entre la valeur initiale de référence de vitesse de rotation du ventilateur « RPM 0 » établie durant le cycle initial d'étapes et la nouvelle valeur de référence de vitesse de rotation du ventilateur, repérée « RPM 0' », est positive. L'étape de diagnostic comprend alors une évaluation de l'usure du ventilateur (induisant des frottements qui génèrent une baisse des valeurs de référence de vitesse de rotation) en fonction de la différence (repérée « Delta RPM 0- ») entre « RPM 0 » établie durant le cycle initial d'étapes et la nouvelle valeur de référence « RPM 0' » de vitesse de rotation du ventilateur. Globalement, il sera établi que plus la différence est grande, plus l'usure du ventilateur est grande.

Dans le deuxième cas, la différence entre la nouvelle valeur de référence de vitesse de rotation du ventilateur, repérée « RPM 0" » et la valeur initiale de référence de vitesse de rotation du ventilateur « RPM 0 » établie durant le cycle initial d'étapes est positive. L'étape de diagnostic comprend alors une vérification de la présence et/ou de la gravimétrie de l'élément de filtration en fonction de la valeur de cette différence positive (repérée « Delta RPM 0+ »). En effet, l'absence d'implantation du filtre ou le choix d'une gravimétrie trop faible engendre concrètement une augmentation des valeurs de référence de vitesse de rotation.

De manière très avantageuse, le procédé de surveillance peut comprendre une étape de détermination de la périodicité repérée « P » (figure 2) de remplacement de l'élément de filtration. La détermination de la périodicité P est réalisée en fonction de la durée de chaque cycle d'étapes. Elle correspond globalement à la durée entre l'instant t1 d'établissement de la valeur de référence de vitesse de rotation pour le cycle correspondant et l'instant où la notification de besoin d'intervention est mise en oeuvre. Dès lors, il devient possible de programmer les opérations de maintenance ou bien de les anticiper par exemple pour les mutualiser pour un ensemble d'appareils.

Enfin, le procédé de surveillance peut comprendre une étape de signalement d'une défaillance du ventilateur lorsque, durant toute étape de suivi (durant n'importe quel cycle d'étapes) de l'évolution dans le temps de la vitesse de rotation du ventilateur, la vitesse de rotation du ventilateur devient nulle. Un arrêt inattendu de la rotation du ventilateur traduit en effet une situation anormale, susceptible de désagréments, il convient dès lors de signaler ce problème à l'utilisateur dès que possible.

Par rapport à l'état de l'art existant, la solution ici décrite permet de contrôler la performance globale de la qualité de passage de l'air dans une armoire de contrôle dotée d'un ventilateur. Avantageusement, l'élément de filtration encrassé ou l'équipement électrique incident peut être localisé et désigné.

La solution décrite ci-dessus peut être utilisée pour tout équipement qui embarque au moins un ventilateur et au moins un filtre associé, tel qu'une alimentation à découpage, une unité centrale d'ordinateur, un composant d'électronique de puissance tel que variateur de vitesse,....

Une application particulièrement visée correspond à la surveillance d'une armoire de contrôle renfermant au moins un organe électrique à réguler thermiquement.

Les figures 4 à 8 illustrent schématiquement des exemples d'armoires de contrôle munies d'un dispositif de surveillance selon l'invention et mettant en oeuvre le procédé de surveillance selon l'invention.

Sur la figure 4, l'armoire de contrôle 10 comprend un système de dissipation thermique avec une ouïe de ventilation 11 agencée sur le toit de l'armoire 10 et un ventilateur 12. Le dispositif de surveillance envoie une information 13 à destination d'une unité de commande 14. Cette information 13 est représentative de la vitesse de rotation du ventilateur 12, notamment du nombre de rotations par minute. L'unité de commande 14 qui appartient au dispositif de surveillance, à partir de l'information 13, met en oeuvre un procédé de surveillance tel que décrit précédemment. A l'étape de notification, l'unité de commande 14 émet un signal 15 assurant la notification de besoin d'intervention. Il s'agit par exemple d'un signal 15 à destination d'une diode de type LED intégrée dans un guide de lumière émissif agencé par exemple au niveau de l'élément de filtration 16. Le guide de lumière peut être constitué par la grille de sortie externe de l'élément de filtration 16, par exemple à l'aide d'une matière polycarbonate translucide. La couleur de la lumière émise par la diode peut être représentative du type de besoin d'intervention : par exemple des couleurs orange ou rouge permettent d'attirer l'attention de l'utilisateur à la manière respectivement d'une alerte et d'une alarme.

Il est possible, pour une armoire de contrôle, de façon avantageuse, grâce au dispositif de surveillance, de signaler de manière visuelle l'élément de filtration encrassé afin de motiver et précipiter l'opération de maintenance préventive.

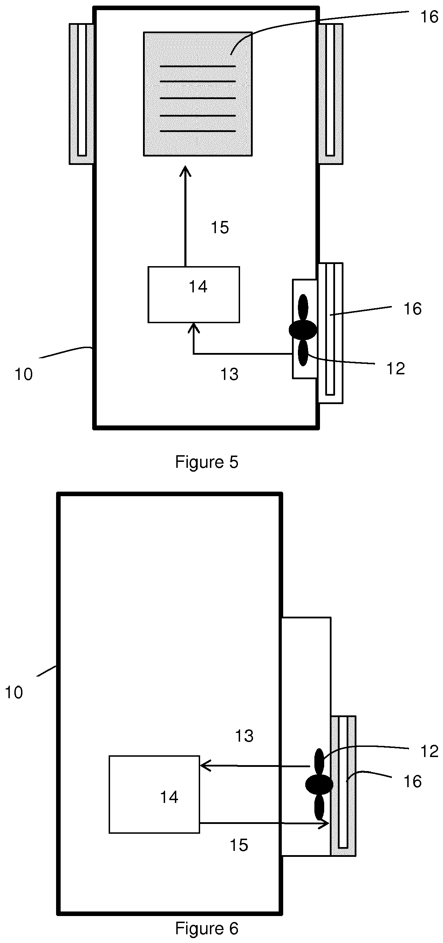

La figure 5 illustre le cas d'une armoire de contrôle pour laquelle le ventilateur 12 est positionné sur les parois latérales de l'armoire, avec un élément de filtration 16 éventuellement lumineux en amont et/ou en aval du ventilateur 12.

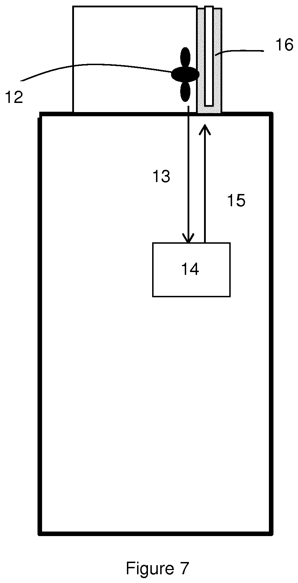

Les figures 6 et 7 illustrent les cas d'armoire de contrôle avec un groupe de froid ou un échangeur implanté respectivement sur une paroi latérale et sur le toit de l'armoire de contrôle 10. Le ventilateur 12 et l'élément de filtration 16 éventuellement lumineux par le signal 15 appartiennent au groupe de froid ou à l'échangeur.

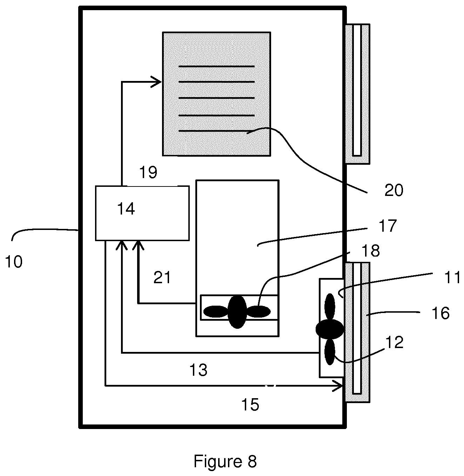

La figure 8 représente le cas particulier d'une armoire de contrôle 10 équipée d'au moins une ouverture de ventilation 11 et renfermant au moins un organe électrique 17 à réguler en température. L'armoire de contrôle 10 comprend au moins un premier système de dissipation thermique placé dans l'armoire de contrôle 10 et ayant un ventilateur 18 régulant la température de l'organe électrique 17 et/ou au moins un deuxième système de dissipation thermique ayant un ventilateur 12 faisant circuler de l'air à travers l'ouverture de ventilation 11 pour amener de l'air dans l'armoire de contrôle 10 et/ou pour extraire de l'air en dehors de l'armoire de contrôle 10. La surveillance de l'armoire de contrôle 10 comprend la mise en oeuvre d'une surveillance telle que précédemment décrite, du fonctionnement du premier système de dissipation thermique et/ou du deuxième système de dissipation thermique.

Le deuxième dispositif de surveillance envoie une information 13 à destination de l'unité de commande 14, représentative de la vitesse de rotation du ventilateur 12, notamment du nombre de rotations par minute. L'unité de commande 14 qui appartient au deuxième dispositif de surveillance, à partir de l'information 13, peut mettre en oeuvre un procédé de surveillance tel que décrit précédemment. A l'étape de notification, l'unité de commande 14 peut émettre un signal 15 à destination d'une diode de type LED intégrée dans un guide de lumière émissif agencé par exemple au niveau de l'élément de filtration 16. Le premier dispositif de surveillance envoie une information 21 à destination de l'unité de commande 14, représentative de la vitesse de rotation du ventilateur 18, notamment du nombre de rotations par minute. L'unité de commande 14 qui appartient aussi au premier dispositif de surveillance, à partir de l'information 21, peut mettre en oeuvre un procédé de surveillance tel que décrit précédemment. A l'étape de notification, l'unité de commande 14 peut émettre un signal 19 à destination d'une diode de type LED intégrée dans un guide de lumière émissif agencé par exemple au niveau d'un autre élément de filtration 20 assurant la sortie de l'air hors de l'armoire 10 lorsqu'il y pénètre par le fonctionnement du ventilateur 12 et/ou du ventilateur 18.

Ainsi, si l'origine de l'incident est due à la souffrance de l'organe électrique 17 (qui est par exemple un variateur de vitesse), l'unité de commande 14 consigne le défaut et allume l'élément de filtration correspondant. L'origine de la panne est éventuellement consignée sur une interface homme-machine de l'unité de commande 14.

## Revendications

1. Procédé de surveillance du fonctionnement d'un système de dissipation thermique comprenant au moins un ventilateur (12, 18) assurant une circulation d'air de refroidissement, comprenant la mise en oeuvre d'au moins un cycle d'étapes au cours duquel le ventilateur fonctionne et comprenant les étapes suivantes :
- établissement d'une valeur de référence de vitesse de rotation du ventilateur (RPM 0) durant le fonctionnement du ventilateur notamment sensiblement en début de cycle,
- suivi de l'évolution dans le temps de la vitesse de rotation du ventilateur (RPM),
- notification d'un besoin d'intervention sur le système de dissipation thermique lorsque le rapport entre la vitesse de rotation du ventilateur (RPM) durant l'étape de suivi et la valeur de référence de vitesse de rotation du ventilateur (RPM 0) établie, est inférieur à un seuil prédéterminé (Δmax) non nul, notamment de l'ordre de 0,75.

2. Procédé selon la revendication 1, **caractérisé en ce que** le système de dissipation thermique comprenant au moins un élément de filtration de l'air (16, 20) circulant lorsque le ventilateur (12, 18) présente une vitesse de rotation (RPM) non nulle, l'étape de notification comprend une étape de signalement de la nécessité de remplacement dudit élément de filtration (16, 20).

3. Procédé selon l'une des revendications 1 ou 2, **caractérisé en ce que** l'étape de notification comprend une étape de signalisation à destination d'un opérateur de maintenance du système de dissipation thermique, notamment une étape de signalisation visuelle, en particulier une étape d'affichage d'un témoin lumineux.

4. Procédé selon l'une des revendications 1 à 3, **caractérisé en ce que** l'étape de suivi comprend une étape de mesure périodique de la vitesse de rotation (RPM) instantanée du ventilateur (12, 18).

5. Procédé selon l'une des revendications 1 à 4, **caractérisé en ce que** l'étape d'établissement de la valeur de référence de vitesse de rotation du ventilateur (RPM 0) comprend une étape de mesure unique de la vitesse de rotation (RPM) instantanée du ventilateur réalisée à la fin d'une période d'apprentissage (TA) de fonctionnement du ventilateur (12, 18) à une vitesse de rotation (RPM) non nulle.

6. Procédé selon l'une des revendications 1 à 5, **caractérisé en ce que** le cycle d'étapes est itératif de sorte que le procédé comprend la mise en oeuvre :
- d'un cycle initial d'étapes dont l'étape d'établissement fournit une valeur initiale de référence de vitesse de rotation du ventilateur (RPM),
- puis d'au moins un cycle d'étapes suivant, pour chacun desquels l'étape d'établissement fournit une nouvelle valeur de référence de vitesse de rotation du ventilateur (RPM 0', RPM 0").

7. Procédé selon la revendication 6, **caractérisé en ce qu'**un cycle d'étapes est mis en oeuvre lors du premier fonctionnement du système de dissipation thermique.

8. Procédé selon l'une des revendications 6 ou 7, **caractérisé en ce qu'**un cycle d'étapes est mis en oeuvre sur demande d'un opérateur de maintenance.

9. Procédé selon l'une des revendications 6 à 8, **caractérisé en ce qu'**un cycle d'étapes est mis en oeuvre automatiquement à chaque démarrage du système de dissipation thermique ou du ventilateur (12, 18).

10. Procédé selon l'une des revendications 6 à 9, **caractérisé en ce qu'**un cycle d'étapes est mis en oeuvre automatiquement à chaque changement de l'élément de filtration (16, 20).

11. Procédé selon l'une des revendications 6 à 10, **caractérisé en ce qu'**à la mise en oeuvre d'un cycle d'étapes suivant le cycle initial d'étapes, le procédé comprend une étape de comparaison de la nouvelle valeur de référence de vitesse de rotation du ventilateur (RPM 0', RPM 0") par rapport à la valeur initiale de référence de vitesse de rotation du ventilateur (RPM 0) établie durant le cycle initial d'étapes, et une étape de diagnostic du système de dissipation thermique en fonction du résultat de l'étape de comparaison.

12. Procédé selon la revendication 11, **caractérisé en ce que** l'étape de diagnostic comprend une étape d'évaluation de l'usure du ventilateur (12, 18) en fonction de la différence entre la valeur initiale de référence de vitesse de rotation du ventilateur (RPM) établie durant le cycle initial d'étapes et la nouvelle valeur de référence de vitesse de rotation du ventilateur (RPM 0', RPM 0") lorsque ladite différence est positive.

13. Procédé selon l'une des revendications 11 ou 12, **caractérisé en ce que** l'étape de diagnostic comprend une étape de vérification de la présence et/ou de la gravimétrie de l'élément de filtration (16, 20) en fonction de la différence entre la nouvelle valeur de référence de vitesse de rotation du ventilateur (RPM 0', RPM 0") et la valeur initiale de référence de vitesse de rotation du ventilateur (RPM 0) établie durant le cycle initial d'étapes lorsque ladite différence est positive.

14. Procédé selon l'une des revendications 1 à 13, **caractérisé en ce qu'**il comprend une étape de détermination de la périodicité (P) de remplacement de l'élément de filtration (16, 20) en fonction de la durée dudit au moins un cycle d'étapes.

15. Procédé selon l'une des revendications 1 à 14, **caractérisé en ce qu'**il comprend une étape de signalement d'une défaillance du ventilateur (12, 18) lorsque, durant toute étape de suivi de l'évolution dans le temps de la vitesse de rotation du ventilateur (12, 18), la vitesse de rotation du ventilateur (RPM) devient nulle.

16. Procédé de surveillance d'une armoire de contrôle (10) renfermant au moins un organe électrique (17) et équipée d'au moins une ouverture de ventilation (11), l'armoire de contrôle (10) comprenant au moins un premier système de dissipation thermique placé dans l'armoire de contrôle (10) et ayant un ventilateur (18) régulant la température de l'organe électrique (17) et/ou au moins un deuxième système de dissipation thermique ayant un ventilateur (12) faisant circuler de l'air à travers l'ouverture de ventilation (11) pour amener de l'air dans l'armoire de contrôle (10) et/ou pour extraire de l'air en dehors de l'armoire de contrôle (10), **caractérisé en ce qu'**il comprend la mise en oeuvre d'un procédé de surveillance du fonctionnement dudit au moins un premier système de dissipation thermique et/ou dudit au moins un deuxième système de dissipation thermique, selon l'une quelconque des revendications précédentes.

17. Dispositif de surveillance du fonctionnement d'un système de dissipation thermique comprenant au moins un ventilateur (12, 18) assurant une circulation d'air de refroidissement, comprenant les éléments logiciels et/ou matériels qui mettent en oeuvre l'un des procédés selon l'une quelconque des revendications 1 à 16.

18. Armoire de contrôle (10) renfermant au moins un organe électrique (17) et équipée d'au moins une ouverture de ventilation (11), l'armoire de contrôle (10) comprenant au moins un premier système de dissipation thermique placé dans l'armoire de contrôle (10) et ayant un ventilateur (18) régulant la température de l'organe électrique (17) et/ou au moins un deuxième système de dissipation thermique ayant un ventilateur (12) faisant circuler de l'air à travers l'ouverture de ventilation (11) pour amener de l'air dans l'armoire de contrôle (10) et/ou pour extraire de l'air en dehors de l'armoire de contrôle (10), **caractérisée en ce qu'**elle comporte au moins un dispositif de surveillance selon la revendication 17 surveillant le fonctionnement dudit au moins un premier système de dissipation thermique et/ou dudit au moins un deuxième système de dissipation thermique.

## Patentansprüche

1. Verfahren zum Überwachen des Betriebs eines Wärmeabführungssystems, das wenigstens einen Ventilator (12, 18) umfasst, der eine Kühlungsluftzirkulation sicherstellt, das umfasst: Ausführen wenigstens eines Zyklus von Schritten, in dessen Verlauf der Ventilator arbeitet und der die folgenden Schritte umfasst:
- Erstellen eines Referenzwerts (RPM 0) der Drehzahl des Ventilators während des Betriebs des Ventilators insbesondere im Wesentlichen am Beginn des Zyklus,
- Verfolgen der zeitlichen Entwicklung der Drehzahl (RPM) des Ventilators,
- Melden eines Bedarfs an einem Eingriff in das Wärmeabführungssystem, wenn das Verhältnis zwischen der Drehzahl (RPM) des Ventilators während des Verfolgungsschrittes und dem erstellten Referenzwert (RPM 0) der Drehzahl des Ventilators kleiner als ein vorgegebener, von null verschiedener Schwellenwert (Δmax), der insbesondere in der Größenordnung von 0,75 liegt, ist.

2. Verfahren nach Anspruch 1, **dadurch gekennzeichnet, dass** dann, wenn das Wärmeabführungssystem wenigstens ein Element (16, 20) zum Filtern der Luft, die zirkuliert, wenn der Ventilator (12, 18) eine von null verschiedene Drehzahl (RPM) hat, aufweist, der Meldeschritt einen Schritt des Meldens der Notwendigkeit des Ersetzens des Filterelements (16, 20) umfasst.

3. Verfahren nach einem der Ansprüche 1 oder 2, **dadurch gekennzeichnet, dass** der Meldeschritt einen Schritt des Meldens an eine Wartungsperson des Wärmeabführungssystems, insbesondere einen Schritt des visuellen Meldens, insbesondere einen Schritt des Anzeigens eines Leuchtzeigers, umfasst.

4. Verfahren nach einem der Ansprüche 1 bis 3, **dadurch gekennzeichnet, dass** der Verfolgungsschritt einen Schritt des periodischen Messens der aktuellen Drehzahl (RPM) des Ventilators (12, 18) umfasst.

5. Verfahren nach einem der Ansprüche 1 bis 4, **dadurch gekennzeichnet, dass** der Schritt des Erstellens des Referenzwerts (RPM 0) der Drehzahl des Ventilators einen einzigen Schritt des Messens der momentanen Drehzahl (RPM) des Ventilators umfasst, der am Ende einer Periode (TA) des Lernens des Betriebs des Ventilators (12, 18) bei einer von null verschiedenen Drehzahl (RPM) ausgeführt wird.

6. Verfahren nach einem der Ansprüche 1 bis 5, **dadurch gekennzeichnet, dass** der Zyklus von Schritten iterativ ist, derart, dass das Verfahren Folgendes ausführt:
- einen anfänglichen Zyklus von Schritten, bei dem der Erstellungsschritt einen anfänglichen Referenzwert der Drehzahl (RPM) des Ventilators liefert,
- dann wenigstens einen folgenden Zyklus von Schritten, wobei für jeden von ihnen der Erstellungsschritt einen neuen Referenzwert (RPM 0', RPM 0") der Drehzahl des Ventilators liefert.

7. Verfahren nach Anspruch 6, **dadurch gekennzeichnet, dass** ein Zyklus von Schritten beim ersten Betrieb des Wärmeabführungssystems ausgeführt wird.

8. Verfahren nach einem der Ansprüche 6 oder 7, **dadurch gekennzeichnet, dass** ein Zyklus von Schritten auf Anforderung von einer Wartungsperson ausgeführt wird.

9. Verfahren nach einem der Ansprüche 6 bis 8, **dadurch gekennzeichnet, dass** ein Zyklus von Schritten automatisch bei jedem Start des Wärmeabführungssystems oder des Ventilators (12, 18) ausgeführt wird.

10. Verfahren nach einem der Ansprüche 6 bis 9, **dadurch gekennzeichnet, dass** ein Zyklus von Schritten bei jedem Wechsel des Filterelements (16, 20) automatisch ausgeführt wird.

11. Verfahren nach einem der Ansprüche 6 bis 10, **dadurch gekennzeichnet, dass** bei der Ausführung eines Zyklus von Schritten nach dem anfänglichen Zyklus von Schritten das Verfahren einen Schritt des Vergleichens des neuen Referenzwerts (RPM 0', RPM 0") der Drehzahl des Ventilators mit dem anfänglichen Referenzwert (RPM 0) der Drehzahl des Ventilators, der während des anfänglichen Zyklus von Schritten erstellt wird, und einen Schritt des Diagnostizierens des Wärmeabführungssystems als Funktion des Ergebnisses des Vergleichsschrittes umfasst.

12. Verfahren nach Anspruch 11, **dadurch gekennzeichnet, dass** der Diagnoseschritt einen Schritt des Bewertens des Verschleißes des Ventilators (12, 18) als Funktion der Differenz zwischen dem anfänglichen Referenzwert (RPM) der Drehzahl des Ventilators, der während des anfänglichen Zyklus von Schritten erstellt wird, und dem neuen Referenzwert (RPM 0', RPM 0") der Drehzahl des Ventilators umfasst, wenn die Differenz positiv ist.

13. Verfahren nach einem der Ansprüche 11 oder 12, **dadurch gekennzeichnet, dass** der Diagnoseschritt einen Schritt des Verifizierens des Vorhandenseins und/oder der Gravimetrie des Filterelements (16, 20) als Funktion der Differenz zwischen dem neuen Referenzwert (RPM 0', RPM 0") der Drehzahl des Ventilators und dem anfänglichen Referenzwert (RPM 0) der Drehzahl des Ventilators, der während des anfänglichen Zyklus von Schritten erstellt wird, umfasst, wenn die Differenz positiv ist.

14. Verfahren nach einem der Ansprüche 1 bis 13, **dadurch gekennzeichnet, dass** es einen Schritt des Bestimmens der Periodizität (P) des Ersetzens des Filterelements (16, 20) als Funktion der Dauer wenigstens eines Zyklus von Schritten umfasst.

15. Verfahren nach einem der Ansprüche 1 bis 14, **dadurch gekennzeichnet, dass** es einen Schritt des Meldens eines Ausfalls des Ventilators (12, 18) umfasst, wenn während des gesamten Schrittes des Verfolgens der zeitlichen Entwicklung der Drehzahl des Ventilators (12, 18) die Drehzahl (RPM) des Ventilators null wird.

16. Verfahren zum Überwachen eines Steuerschranks (10), der wenigstens ein elektrisches Organ (17) umgibt und mit wenigstens einer Belüftungsöffnung (11) versehen ist, wobei der Steuerschrank (10) wenigstens ein erstes Wärmeabführungssystem, das in dem Steuerschrank (10) angeordnet ist und einen Ventilator (18) besitzt, der die Temperatur des elektrischen Organs (17) reguliert, und/oder wenigstens ein zweites Wärmeabführungssystem, das einen Ventilator (12) besitzt, der eine Zirkulation der Luft durch die Belüftungsöffnung (11) bewirkt, um die Luft dem Steuerschrank (10) zuzuführen und/oder um die Luft aus dem Steuerschrank (10) abzuführen, umfasst, **dadurch gekennzeichnet, dass** es die Ausführung eines Verfahrens zum Überwachen des Betriebs des wenigstens einen ersten Wärmeabführungssystems und/oder des wenigstens einen zweiten Wärmeabführungssystems nach einem der vorhergehenden Ansprüche umfasst.

17. Vorrichtung zum Überwachen des Betriebs eines Wärmeabführungssystems, das wenigstens einen Ventilator (12, 18) umfasst, der eine Zirkulation von Kühlungsluft sicherstellt, die die Software- und/oder Hardware-Elemente enthält, die eines der Verfahren nach einem der Ansprüche 1 bis 16 ausführen.

18. Steuerschrank (10), der wenigstens ein elektrisches Organ (17) umgibt und mit wenigstens einer Belüftungsöffnung (11) versehen ist, wobei der Steuerschrank (10) wenigstens ein erstes Wärmeabführungssystem, das in dem Steuerschrank (10) angeordnet ist und einen Ventilator (18) besitzt, der die Temperatur des elektrischen Organs (17) reguliert, und/oder wenigstens ein zweites Wärmeabführungssystem, das einen Ventilator (12) besitzt, der eine Zirkulation von Luft durch die Belüftungsöffnung (11) bewirkt, um die Luft dem Steuerschrank (10) zuzuführen und/oder um die Luft aus dem Steuerschrank (10) abzuführen, umfasst, **dadurch gekennzeichnet, dass** er wenigstens eine Überwachungsvorrichtung nach Anspruch 17 umfasst, die den Betrieb des wenigstens einen ersten Wärmeabführungssystems und/oder des wenigstens einen zweiten Wärmeabführungssystems überwacht.

## Claims

1. Method for monitoring the operation of a heat dissipation system comprising at least one fan (12, 18) that circulates cooling air, involving performing at least one cycle of steps during which the fan operates and comprising the following steps:
- establishing a reference value for the rotational speed of the fan (RPM 0) during operation of the fan notably substantially at the start of the cycle,
- monitoring the evolution with respect to time of the rotational speed of the fan (RPM),
- notifying a need to intervene on the heat dissipation system when the ratio between the rotational speed of the fan (RPM) during the monitoring step and the established reference value for the rotational speed of the fan (RPM 0) is below a non-zero predetermined threshold (Δmax), notably of the order of 0.75.

2. Method according to Claim 1, **characterized in that** the heat dissipation system comprising at least one air filtration element (16, 20) that filters the air circulating when the fan (12, 18) has a non-zero rotational speed (RPM), the notification step comprises a step of signalling the need to replace the said filtration element (16, 20).

3. Method according to one of Claims 1 and 2, **characterized in that** the notification step comprises a step of signalling to a maintenance operator who maintains the heat dissipation system, notably a step of visual signalling, particularly a step of illuminating an indicator lamp.

4. Method according to one of Claims 1 to 3, **characterized in that** the monitoring step comprises a step of periodically measuring the instantaneous rotational speed (RPM) of the fan (12, 18).

5. Method according to one of Claims 1 to 4, **characterized in that** the step of establishing the reference value for the rotational speed of the fan (RPM 0) comprises a step of single measurement of the instantaneous rotational speed (RPM) of the fan performed at the end of a learning period (TA) of operation of the fan (12, 18) at a non-zero rotational speed (RPM).

6. Method according to one of Claims 1 to 5, **characterized in that** the cycle of steps is iterative such that the method involves performing:
- an initial cycle of steps in which the establishing step provides an initial reference value for the rotational speed of the fan (RPM),
- then at least one subsequent cycle of steps, for each of which the establishing step provides a new reference value for the rotational speed of the fan (RPM 0', RPM 0").

7. Method according to Claim 6, **characterized in that** a cycle of steps is performed when the heat dissipation system is first brought into operation.

8. Method according to one of Claims 6 and 7, **characterized in that** a cycle of steps is performed at the demand of a maintenance operator.

9. Method according to one of Claims 6 to 8, **characterized in that** a cycle of steps is performed automatically each time the heat dissipation system or the fan (12, 18) is started.

10. Method according to one of Claims 6 to 9, **characterized in that** a cycle of steps is performed automatically each time the filtration element (16, 20) is changed.

11. Method according to one of Claims 6 to 10, **characterized in that** when a cycle of steps following the initial cycle of steps is performed, the method comprises a step of comparing the new reference value for the rotational speed of the fan (RPM 0', RPM 0") against the initial reference value for the rotational speed of the fan (RPM 0) established during the initial cycle of steps, and a step of diagnosing the heat dissipation system according to the result of the comparison step.

12. Method according to Claim 11, **characterized in that** the diagnosing step comprises a step of assessing the wear of the fan (12, 18) according to the difference between the initial reference value for the rotational speed of the fan (RPM) established during the initial cycle of steps and the new reference value for the rotational speed of the fan (RPM 0', RPM 0") when the said difference is positive.

13. Method according to one of Claims 11 and 12, **characterized in that** the diagnosing step comprises a step of verifying the presence and/or the gravimetry of the filtration element (16, 20) according to the difference between the new reference value for the rotational speed of the fan (RPM 0', RPM 0") and the initial reference value for the rotational speed of the fan (RPM 0) established during the initial cycle of steps when the said difference is positive.

14. Method according to one of Claims 1 to 13, **characterized in that** it comprises a step of determining the interval (P) at which the filtration element (16, 20) is replaced, according to the duration of the said at least one cycle of steps.

15. Method according to one of Claims 1 to 14, **characterized in that** it comprises a step of signalling a failure of the fan (12, 18) when, during any step in the monitoring of the evolution with respect to time of the rotational speed of the fan (12, 18), the rotational speed of the fan (RPM) becomes zero.

16. Method for monitoring a control cabinet (10) enclosing at least one electrical component (17) and equipped with at least one ventilation opening (11), the control cabinet (10) comprising at least one first heat dissipation system placed in the control cabinet (10) and having a fan (18) regulating the temperature of the electric component (17) and/or at least one second heat dissipation system having a fan (12) circulating air through the ventilation opening (11) to convey air into the control cabinet (10) and/or to extract air from the control cabinet (10), **characterized in that** it comprises implementing a method for monitoring the operation of the said at least one first heat dissipation system and/or of the said at least one second heat dissipation system according to any one of the preceding claims.

17. Device for monitoring the operation of a heat dissipation system comprising at least one fan (12, 18) that circulates cooling air, comprising the software and/or hardware elements that implement one of the methods according to any one of Claims 1 to 16.

18. Control cabinet (10) enclosing at least one electrical component (17) and equipped with at least one ventilation opening (11), the control cabinet (10) comprising at least one first heat dissipation system placed in the control cabinet (10) and having a fan (18) regulating the temperature of the electric component (17) and/or at least one second heat dissipation system having a fan (12) circulating air through the ventilation opening (11) to convey air into the control cabinet (10) and/or to extract air from the control cabinet (10), **characterized in that** it comprises at least one monitoring device according to Claim 17 monitoring the operation of the said at least one first heat dissipation system and/or of the said at least one second heat dissipation system.
